# FASCICULE DE BREVET EUROPEEN

(11) **EP 1 014 439 B1**
(45) Date de publication et mention de la délivrance du brevet: **07.03.2007**
(21) Numéro de dépôt: 99402414.9
(22) Date de dépôt: 01.10.1999
(51) Int. Cl.: H01L 21/768, H01L 23/522

(54) **Procédé de réalisation d'un isolement inter et/ou intra-métallique par air dans un circuit intégré**
Herstellungsverfahren für ein Zwischenmetalldielektrikum aus Luft in einer integrierten Schaltung
Method of manufacturing an inter- or intra-metal dielectric comprising air in an integrated circuit

(30) Priorité: 05.10.1998 FR 9812444
(43) Date de publication de la demande: 28.06.2000
(73) Titulaire: STMicroelectronics S.A., 92120 Montrouge (FR); FRANCE TELECOM, 75015 Paris (FR)
(72) Inventeur: Alieu, Jérome, 38080 Isle d'Abeau (FR); Lair, Christophe, 38190 Brignoud (FR); Haond, Michel, 38920 Crolles (FR)
(74) Mandataire: Casalonga, Axel

(56) Documents cités:
- US-A- 5 461 003
- US-A- 5 598 026

## Description

La présente invention concerne de manière générale l'isolation des éléments métalliques conducteurs des différents niveaux de métallisation d'un circuit intégré et plus particulièrement un procédé pour réaliser une telle isolation des éléments métalliques conducteurs du circuit intégré par de l'air.

L'invention concerne également un circuit intégré dans lequel au moins une partie des éléments métalliques conducteurs des différents niveaux de métallisation du circuit sont isolés entre eux au moyen d'air.

La rapidité de fonctionnement d'un circuit intégré dépend de sa capacité (C) totale. Cette capacité totale se compose des capacités du dispositif semi-conducteur (capacité de jonction, capacité grille-drain, etc...) ainsi que de la capacité d'inter-connexion.

La capacité d'inter-connexion comprend elle-même deux capacités, la capacité entre les éléments métalliques conducteurs d'un même niveau de métallisation généralement appelée capacité intra-métallique et la capacité entre des éléments métalliques conducteurs de deux niveaux de métallisation successifs du circuit intégré, généralement appelée capacité inter-métallique.

La capacité du dispositif et la capacité d'inter-connexion représentent respectivement environ 30 et 70% de la capacité totale du circuit intégré. On voit donc immédiatement l'intérêt qu'il y a de réduire la plus importante de ces deux capacités, c'est-à-dire la capacité d'inter-connexion. D'autre part, dans la capacité d'inter-connexion, la capacité intra-métallique est la plus importante.

L'air est le meilleur diélectrique connu ayant la constante diélectrique la plus faible, et par conséquent, il serait souhaitable de pouvoir réaliser des isolations inter et intra-métalliques dans les circuits intégrés au moyen d'air.

US-A-5,461,003 décrit un procédé de réalisation de tranchées d'air isolantes entre des pistes métalliques, comprenant le dépôt d'une couche de polymères dans une partie des espaces entre lesdites pistes métalliques, et l'élimination de la couche de polymères pour former les tranchées remplies d'air.

US-A-5,598,026 décrit l'utilisation d'oxyde de germanium GeOₓ comme matériau pouvant être extrait sélectivement afin de former une couche poreuse isolante.

L'article "Use of Gas as Low-k Interlayer Dielectric in LSI's : Demonstration of Feasibility", M.B. Anand, Masaki Yamada, et Hideki Shibata (utilisation de gaz comme diélectrique intercouche à faible k dans les LSI : démonstration de faisabilité), I.E.E.E. Transaction on Electron Devices, vol. 44, n° 11, Novembre 1997, décrit un procédé de réalisation d'isolement intra-métallique par air.

Selon ce procédé, on dépose sur le film isolant séparant deux niveaux de métallisation adjacents, par pulvérisation, une couche de carbone d'épaisseur égale à celle voulue pour les éléments métalliques conducteurs d'inter-connexion. On forme alors dans le film de carbone les évidements destinés à recevoir les éléments métalliques conducteurs et du métal est ensuite déposé par dépôt chimique en phase vapeur ou dépôt physique en phase vapeur dans ces évidements puis l'ensemble est soumis à un polissage mécano-chimique classique pour réaliser les éléments métalliques conducteurs d'inter-connexion dans les évidements. Une mince couche de matériau isolant d'une épaisseur généralement de l'ordre de 50 nm est alors déposée sur la totalité de la surface, par exemple un film de dioxyde de silicium déposé par pulvérisation. Ensuite, l'ensemble est soumis à un traitement thermique dans un four à atmosphère d'oxygène, typiquement à une température d'environ 450°C. L'oxygène, diffuse à travers le mince film de matériau isolant, réagit avec le carbone, le converti en dioxyde de carbone de sorte que les espaces entre l'élément métallique conducteur finissent par être remplis avec du gaz.

L'article mentionne encore que le procédé peut être utilisé également pour réaliser l'isolation intra et inter-métallique.

Un inconvénient majeur du procédé décrit dans le document ci-dessus est l'utilisation du carbone, car le carbone est un contaminant rédhibitoire des appareillages utilisés pour la production des circuits intégrés.

Un autre inconvénient du procédé est qu'il nécessite un chauffage dans un four en atmosphère d'oxygène à une température aussi élevée que 450°C pour oxyder le carbone et le transformer en CO₂, température élevée qui peut nuire à l'intégrité du circuit intégré. En outre, afin de réaliser l'isolement par de l'air, le CO₂ formé doit diffuser à travers la mince couche de SiO₂ ce qui manifestement nuit à l'efficacité du procédé.

La présente invention a donc pour objet de fournir un procédé de réalisation d'un isolement intra et/ou inter-métallique par air dans un circuit intégré qui remédie aux inconvénients de l'art antérieur.

En particulier, la présente invention a pour objet un tel procédé qui évite l'utilisation de carbone.

La présente invention a encore pour objet un tel procédé qui soit simple et rapide et qui ne risque pas de contaminer les appareillages utilisées pour la production des circuits intégrés.

On atteint les objectifs ci-dessus, selon l'invention, au moyen d'un procédé de réalisation d'un isolement intra et/ou inter-métallique par air d'au moins une partie des éléments métalliques conducteurs des niveaux de métallisation du circuit intégré, caractérisé en ce qu'il comprend :
a) le dépôt de germanium polycristallin dans au moins une partie des espaces inter-connexions entre lesdits éléments métalliques conducteurs ; et
b) le retrait du germanium polycristallin pour former des espaces inter-connexions remplis d'air entre lesdits éléments métalliques conducteurs.

Le germanium polycristallin est un matériau unique dans le procédé de la présente invention car le germanium réagit fortement avec l'oxygène, à température ambiante, par exemple l'oxygène ou un oxydant, pour former des composés aisément éliminables, à savoir GeO qui est volatil, GeO₂ qui se dissout dans de l'eau et GeOH₄ qui se dissout dans un acide dilué.

Il est donc extrêmement aisé d'éliminer le germanium polycristallin au moyen par exemple d'une chimie oxygénée adaptée, telle que par dissolution dans l'eau, l'eau oxygénée, des solutions diluées de H₂SO₄ afin de ne laisser à la place du germanium que de l'air comme isolant inter-connexion.

Cette dissolution au moyen d'une chimie oxygénée appropriée à l'avantage de pouvoir s'effectuer à température ambiante. On peut bien évidemment procéder à une température supérieure à la température ambiante, ne dépassant pas généralement 200°C, pour accélérer le processus de retrait du germanium.

Il est également possible d'effectuer le retrait du germanium au moyen d'un plasma oxydant, tel que par exemple un plasma d'oxygène ou d'ozone.

Enfin, le germanium n'est pas un élément chimique critique dans la fabrication des circuits intégrés et pour la technologie du silicium car ce n'est pas un contaminant du silicium.

On peut, si on le souhaite, déposer, préalablement au dépôt de germanium polycristallin, une couche isolante par exemple de SiO₂, pour protéger les éléments métalliques d'un contact direct avec le germanium.

Dans une première mise en oeuvre préférée du procédé de l'invention on réalise une isolation par air intra-métallique entre des éléments métalliques conducteurs d'un même niveau de métallisation caractérisé en ce qu'il comprend :
(1) le dépôt dans les espaces inter-connexions entre les éléments métalliques de germanium polycristallin ;
(2) le dépôt sur les éléments métalliques et le germanium polycristallin d'une couche d'un matériau d'isolation ;
(3) la formation sur la couche de matériau d'isolation d'un masque de résine photo-résistante ;
(4) la gravure anisotrope de la couche de matériau d'isolation pour former dans cette couche des ouvertures en regard du germanium polycristallin ; et
(5) l'élimination du germanium polycristallin pour réaliser des espaces inter-connexions remplis d'air.

Une fois le germanium polycristallin éliminé, on peut déposer une couche d'un matériau isolant d'encapsulation pour clore les espaces inter-connexions remplis d'air.

En variante, on peut remplir certains des espaces inter-connexions avec le matériau isolant d'encapsulation ou un autre matériau isolant solide.

Dans une deuxième mise en oeuvre préférée du procédé de l'invention on réalise une isolation par air inter et intra-métallique entre au moins une partie des éléments métalliques conducteurs des niveaux de métallisation d'un circuit intégré, caractérisé en ce qu'il comprend :
(1) le dépôt, de germanium polycristallin entre et sur les éléments métalliques conducteurs d'un niveau (i) de métallisation ;
(2) la formation, pour ce niveau (i) de métallisation, des vias métalliques voulus, cette formation des vias ayant pour résultat de laisser une couche de matériau isolant sur la surface du dépôt de germanium polycristallin ;
(3) la formation des éléments métalliques conducteurs d'un niveau adjacent (i + 1) de métallisation sur la surface de la couche de matériau isolant recouvrant le dépôt de germanium ;
(4) la gravure de la couche de matériau isolant couvrant la surface du dépôt de germanium pour faire apparaître le dépôt de germanium en des emplacements choisis entre les éléments métalliques du niveau adjacent (i + 1) de métallisation ;
(5) la répétition des étapes (1) à (4) jusqu'à obtention du nombre voulu de niveaux de métallisation, de sorte qu'on obtient un empilement du nombre voulu de niveaux de métallisation dans lequel les dépôts de germanium forment une masse de germanium ininterrompue jusqu'à la surface de l'empilement ; et
(6) l'élimination de la masse de germanium ininterrompue pour former des espaces inter-connexions remplis d'air.

Dans une troisième mise en oeuvre préférée du procédé de l'invention on réalise une isolation par air inter et intra-métallique entre une partie au moins des éléments métalliques conducteurs des niveaux de métallisation d'un circuit intégré, caractérisé en ce qu'il comprend :
(1) le dépôt de germanium polycristallin entre et sur les éléments métalliques conducteurs d'un niveau (i) de métallisation ;
(2) la formation, pour ce niveau (i) de métallisation, des vias métalliques voulus, cette formation des vias ayant pour résultat de laisser une couche de matériau isolant sur la surface du dépôt de germanium polycristallin ;
(3) la formation des éléments métalliques conducteurs d'un niveau adjacent (i + 1) de métallisation sur la surface de la couche de matériau isolant recouvrant le dépôt de germanium ;
(4) la gravure de la couche de matériau isolant couvrant la surface du dépôt de .germanium pour faire apparaître le dépôt de germanium en des emplacements choisis entre les éléments métalliques du niveau adjacent (i + 1) de métallisation ;
(5) l'élimination du germanium pour former des espaces inter-connexions remplis d'air dans le niveau de métallisation ;
(6) le dépôt d'une couche de matériau isolant intermétallique pour clore les espaces inter-connexions remplis d'air du niveau de métallisation (i) ; et
(7) la répétition des étapes (1) à (6) jusqu'à obtention d'un empilement du nombre voulu de niveaux de métallisation comportant des espaces inter-connexions remplis d'air.

La suite de la description se réfère aux figures annexées qui représentent respectivement :
- figures la à 1f schématiquement, les étapes principales de réalisation d'un isolement intra-métallique par air selon le procédé de l'invention ;
- figures 2a à 2d, schématiquement les étapes principales de réalisation d'un isolement mixte intra-métallique par air et au moyen d'un matériau d'isolation solide classique ;
- figures 3a à 3i, schématiquement, les principales étapes de formation de vias dans un procédé de réalisation d'isolement par air intra et inter-métallique selon l'invention ;
- figures 4a et 4b, schématiquement, les principales étapes de formation d'un isolement inter et intra-métallique par air, après formation des vias, selon une première réalisation du procédé de l'invention ; et
- figures 5a à 5d, schématiquement, les différentes étapes de réalisation d'un isolement inter et intra-métallique par air, après formation des vias, selon une autre réalisation du procédé de l'invention.

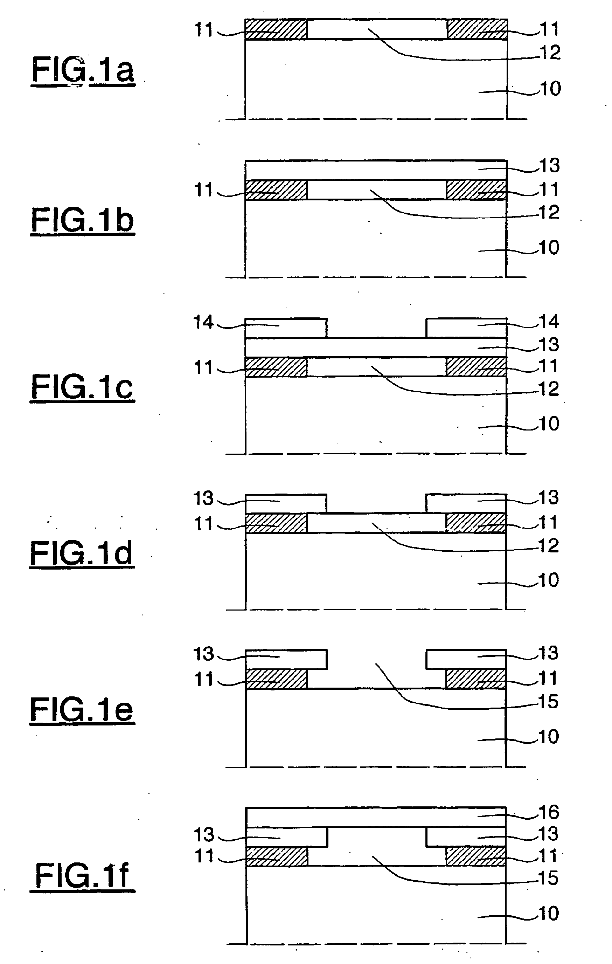

En se référant aux figures 1a à 1f on va maintenant décrire une application du procédé de l'invention à la réalisation d'un isolement intra-métallique par air.

Après avoir formé de façon classique sur un substrat 10 qui peut être un substrat, semi-conducteur de silicium recouvert d'une couche d'un isolant configuré (contacts ou vias) ou un niveau de métallisation d'un circuit intégré recouvert d'une couche d'un isolant configuré (contacts ou vias), les éléments métalliques conducteurs 11, on procède, comme le montre la figure 1a, au dépôt, par exemple par dépôt chimique en phase vapeur, d'une couche de germanium et au polissage mécano-chimique de cette couche pour remplir les espaces inter-connexions entre les éléments métalliques 11 avec du germanium polycristallin 12.

Facultativement, préalablement au dépôt du germanium polycristallin 12, on peut déposer sur les éléments métalliques conducteurs 11 et la surface libre du substrat 10 un mince film de protection, tel qu'un film de SiO₂ de 5 à 50 nm d'épaisseur typiquement de l'ordre de 20 nm d'épaisseur. Le dépôt de ce film de protection peut se faire de toute manière classique, par exemple par dépôt chimique en phase vapeur (CVD) ou dépôt physique en phase vapeur (PVD). Ce mince film de protection a pour but essentiel de protéger les éléments métalliques 11 lors des étapes ultérieures de réalisation du circuit intégré. La présence de ce film d'oxyde de protection permet également de réaliser de manière classique le polissage mécano-chimique du germanium polycristallin déposé avec arrêt sur la couche d'oxyde.

On dépose ensuite de manière classique, comme le montre la figure 1b, un mince film de matériau isolant 13, par exemple un mince film de SiO₂ déposé par dépôt chimique en phase vapeur de façon à recouvrir avec ce film les éléments métalliques 11 éventuellement déjà revêtus d'un film d'oxyde de protection et le germanium polycristallin 12 déposé dans les espaces inter-connexions.

On forme ensuite, toujours de manière classique, un masque d'une résine photo-résistante 14 sur le film de matériau isolant 13 (figure 1c). Comme le montre la figure 1d on procède alors à la gravure du film isolant 13, par exemple une gravure anisotrope classique d'un film de SiO₂, et au retrait également classique du masque de résine photo-résistante 14. La gravure du film isolant 13 conduit à la formation d'un évidement faisant apparaître le germanium polycristallin 12 entre les éléments métalliques 11.

Comme le montre la figure le, on procède alors au retrait du germanium, par exemple par action d'une solution oxydante telle que de l'eau, une solution d'eau oxygénée, une solution diluée d'acide sulfurique ou encore au moyen d'un plasma oxydant tel qu'un plasma d'oxygène ou d'ozone pour obtenir un espace inter-connexion rempli d'air 15.

Il n'est pas nécessaire de retirer le masque de résine photo-résistante 14 avant le retrait du germanium polycristallin 12, mais ce retrait de la résine photo-résistante pourrait tout aussi bien s'effectuer après le retrait du germanium polycristallin ou simultanément avec celui-ci. Ce retrait de la résine peut se faire de manière classique, par exemple au moyen d'un plasma d'oxygène ou d'ozone.

On effectue ensuite le dépôt et le recuit de manière classique d'un film d'isolation 16, par exemple un mince film de SiO₂, SiOF ou d'hydrure de silsesquioxane (HSQ) comme représenté à la figure 1f.

On peut alors poursuivre la fabrication du circuit intégré de manière classique, par exemple par dépôt et polissage mécano-chimique d'une couche d'encapsulation, telle qu'une couche formée à partir de tétraorthosilicate d'éthyle (TEOS) puis en procédant aux étapes standards.

Afin d'éviter que l'espace inter-connexion 15 soit rempli avec le matériau du mince film d'isolation 16 et de la couche d'encapsulation, on peut soit régler la viscosité des compositions de dépôt ou encore régler la dimension des ouvertures gravées. Ainsi, avec des ouvertures gravées de dimension au plus égale à 0,2 µm on évite le remplissage des espaces inter-connexions avec les matériaux des couches ultérieures.

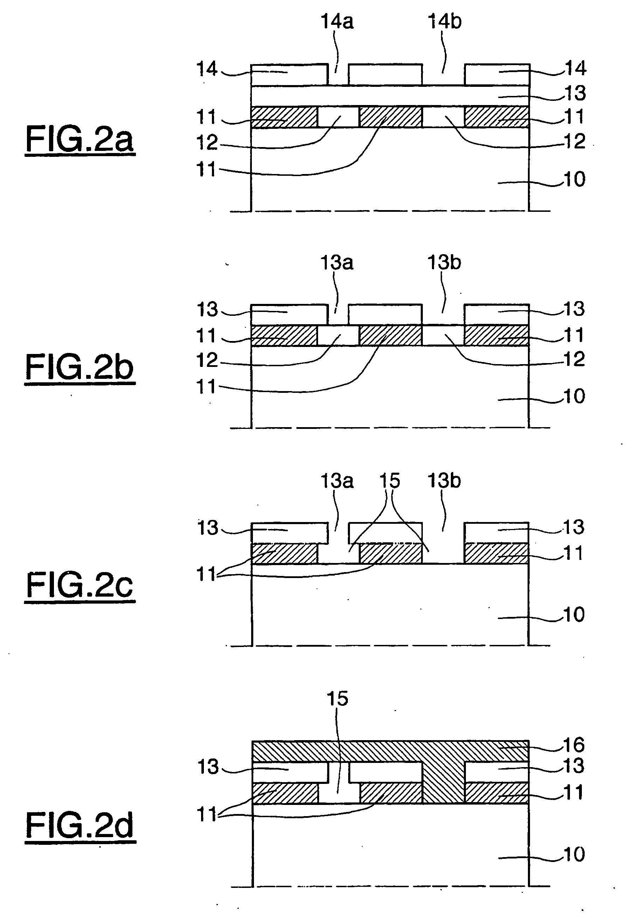

On va maintenant décrire en liaison avec les figures 2a à 2d la réalisation d'un isolement mixte par air et au moyen d'un matériau isolant solide selon le procédé de l'invention.

Comme décrit précédemment, le procédé débute éventuellement par le dépôt d'une mince couche de protection, par exemple en oxyde de silicium, sur les éléments métalliques 11, puis on procède au dépôt d'une couche de germanium polycristallin et au polissage mécano-chimique de cette couche, avec éventuellement arrêt sur oxyde lorsque la couche de protection d'oxyde silicium est présente, pour remplir les espaces inter-connexions entre les éléments métalliques 11 avec du germanium polycristallin 12. Comme précédemment également, on forme alors successivement, comme le montre la figure 2a un mince film de matériau isolant 13, par exemple un mince film d'oxyde de silicium, puis un masque de résine photo-résistante 14 présentant des ouvertures 14a, 14b de dimensions différentes.

On procède alors comme précédemment à la gravure du mince film d'oxyde de silicium 13 et au retrait du masque de résine photo-résistante 14 de manière à former dans le mince film d'oxyde de silicium 13 des ouvertures de tailles différentes 13a et 13b en regard du germanium polycristallin déposé entre les éléments métalliques conducteurs 11 (figure 2b).

Ainsi, par exemple, l'ouverture 13a peut être de très petite taille (≤ 0,2 µm) et l'ouverture 13b de grande taille (>> 0,2 µm).

Comme le montre la figure 2c, on effectue alors comme précédemment le retrait du germanium polycristallin.

On pourrait tout aussi bien procéder au retrait du masque de résine photo-résistante après le retrait du germanium polycristallin ou simultanément avec celui-ci.

Enfin, on procède au dépôt et recuit classiques d'une couche 16 de matériau isolant, par exemple une couche d'oxyde de silicium, de SiOF ou d'hydrure de silsesquioxane (HSQ), qui, comme le montre la figure 2d du fait de la différence de dimensions des ouvertures 13a et 13b, ne pénètre pas par l'ouverture de plus petite dimension 13a, fermant ainsi l'espace inter-connexion et réalisant une isolation par air, cependant qu'il va pénétrer par la plus grande ouverture 13b et réaliser une isolation en matériau solide de l'autre espace inter-connexion comme on le voit sur la figure 2d.

On procède alors généralement de manière classique au dépôt d'une couche d'encapsulation, par exemple de tétraorthoéthylsilicate et polissage mécano-chimique de cette couche puis on achève le circuit intégré de manière standard.

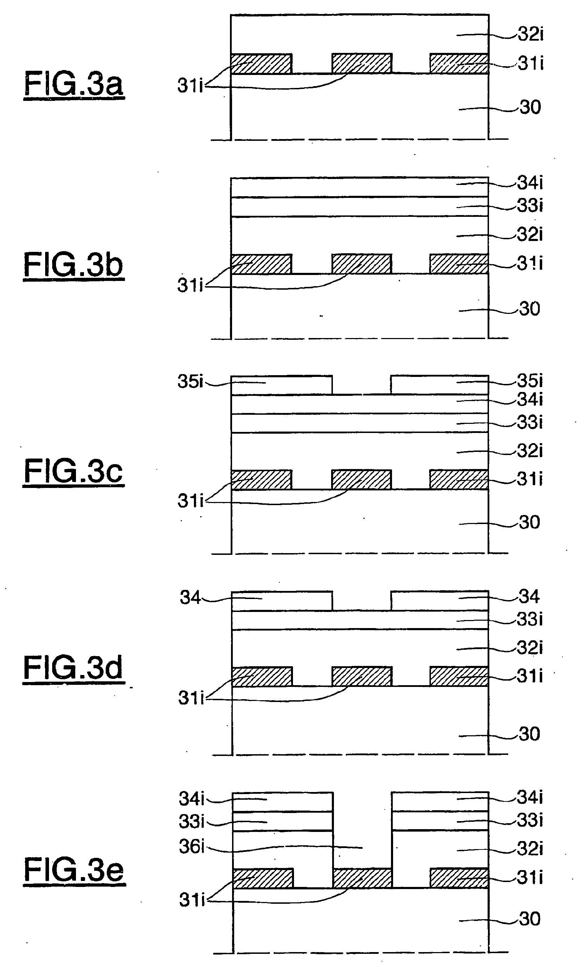

On va maintenant décrire en liaison avec les figures 3a à 3i, 4a, 4b et 5a à 5d, la réalisation d'un isolation par air intra et inter-métallique.

Comme cela est bien connu, la connexion électrique nécessaire entre des éléments métalliques conducteurs de différents niveaux de métallisation du circuit intégré s'effectue au moyen de "vias", c'est-à-dire de passages remplis de métal reliant électriquement des éléments métalliques d'un niveau de métallisation à ceux correspondant d'un niveau adjacent de métallisation.

On va maintenant décrire en liaison avec les figures 3a à 3i la réalisation de tels vias dans un procédé selon l'invention.

La réalisation de vias selon l'invention débute par le dépôt d'une couche 32i de germanium polycristallin sur la surface d'un substrat 30 qui peut être, soit un substrat semi-conducteur de silicium revêtu d'une couche d'isolant configuré (contacts ou vias), soit un niveau de métallisation inférieur, et comportant des éléments métalliques conducteurs 31i (figure 3a). Le dépôt de germanium polycristallin 32i peut s'effectuer classiquement par dépôt chimique en phase vapeur et est généralement suivi par un polissage mécano-chimique. Toutefois, la couche de germanium polycristallin déposée doit être suffisamment épaisse pour permettre la réalisation de vias entre deux niveaux de métallisation successifs. C'est-à-dire que non seulement la couche de germanium polycristallin rempli les espaces inter-connexions mais elle recouvre les éléments métalliques 31i avec une épaisseur suffisante pour pouvoir y former des vias, typiquement de l'ordre de 1 µm.

On procède alors comme le montre la figure 3b au dépôt d'une couche d'arrêt 33i, par exemple une couche de nitrure de silicium (Si₃N₄), qui peut être déposée par exemple par dépôt chimique en phase vapeur assistée par plasma, puis au dépôt, de manière classique d'une couche 34i, par exemple une couche d'oxyde de silicium, servant à la formation d'un masque dur.

Comme le montre la figure 3c on réalise alors sur la couche 34i un masque de résine photo-résistante 35i.

De manière classique on procède alors comme le montre la figure 3d à la gravure de la couche 34i avec arrêt sur la couche d'arrêt 33i et au retrait du masque de résine, pour former un masque dur.

On procède ensuite comme le montre la figure 3e à la gravure de la couche d'arrêt 33i et de la couche de germanium 32i pour former le passage ou via 36i jusqu'à l'élément métallique conducteur 31i.

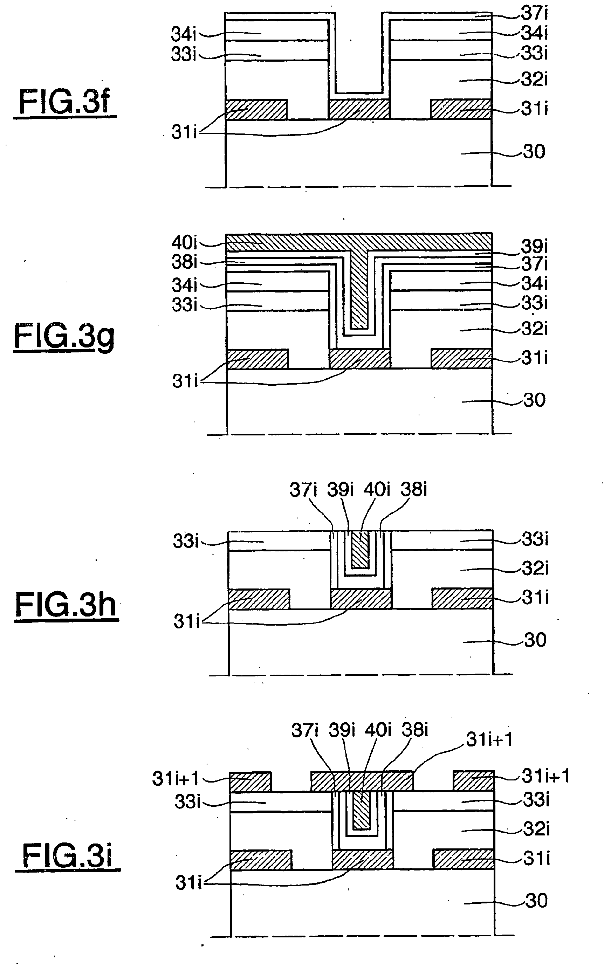

On effectue alors de manière classique le dépôt d'une couche 37i de protection du via 36i, par exemple une mince couche d'oxyde de silicium, puis aux dépôts successifs de couches de protection du via, par exemple une couche de titane 38i avec une phase d'attaque de l'oxyde au fond de via et une couche de nitrure de titane 39i, et enfin on remplit le via avec du métal, par exemple du tungstène 40i (figures 3f et 3g).

A ce stade comme le montre la figure 3h, on procède au polissage mécano-chimique avec arrêt sur la couche d'arrêt 33i de façon à faire apparaître le via rempli de métal 40i.

La réalisation de vias décrite ci-dessus est classique à l'exception de l'emploi de couches du germanium polycristallin.

Bien évidemment le procédé de gravure des vias utilisé doit permettre la gravure anisotrope de germanium polycristallin. Un procédé de gravure du germanium polycristallin comprend l'utilisation d'un plasma gazeux haute densité d'un mélange de gaz Cl₂ et, soit N₂ ou NH₃, soit un mélange N₂/NH₃.

Comme le montre alors la figure 3i, on réalise de manière classique des éléments métalliques conducteurs 31i + 1 du niveau de métallisation immédiatement supérieur i + 1.

Deux voies s'offrent alors pour réaliser les niveaux de métallisation successifs et l'isolement par air selon l'invention.

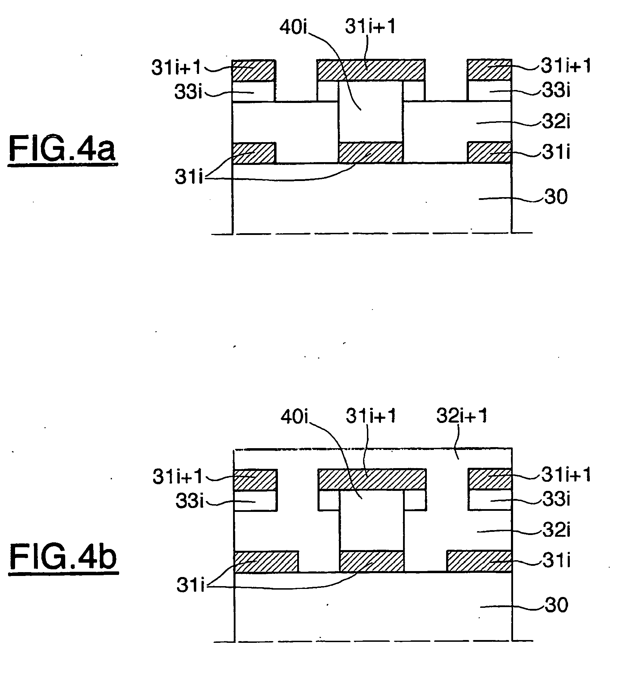

Selon une première voie illustrée aux figures 4a et 4b, on procède à une étape de gravure de la couche d'arrêt 33i du niveau de métallisation i pour faire apparaître le germanium polycristallin 32i sous-jacent (figure 4a) puis on dépose, par dépôt chimique en phase vapeur comme précédemment une nouvelle couche de germanium polycristallin 32i + 1 pour le niveau de métallisation i + 1 analogue à la couche de germanium 32i du niveau de métallisation i puis on procède à la formation de vias pour le niveau supérieur i + 2 comme indiqué ci-dessus. On répète cette opération autant de fois que nécessaire pour obtenir le nombre de niveaux de métallisation voulu.

Une fois tous les niveaux de métallisation formés, les dépôts de germanium polycristallin de tous les niveaux de métallisation forment une masse unitaire jusqu'au niveau supérieur terminal et on procède en une seule fois à l'élimination de toute la masse de germanium. Cette élimination peut se faire comme précédemment au moyen d'une chimie oxydante.

On procède alors à l'achèvement du circuit intégré, par exemple en déposant une couche d'encapsulation sur le dernier niveau de métallisation réalisant ainsi une isolation par air inter et intra-métallique de tous les niveaux de métallisation.

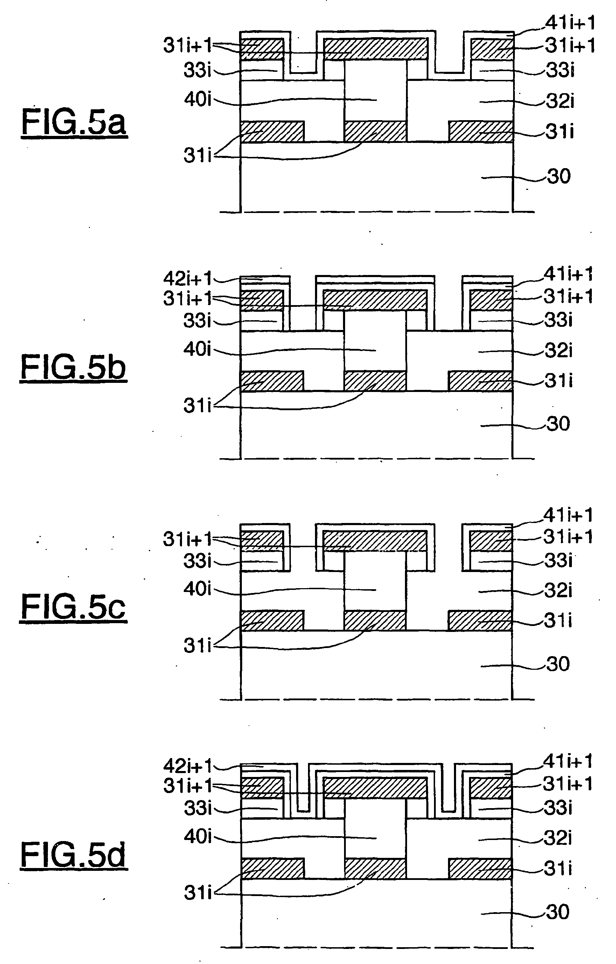

En variante, comme le montrent les figures 5a à 5d, on peut après gravure de la couche d'arrêt 33i déposer une couche isolante mince, par exemple une couche d'oxyde de silicium, 41i + 1 (figure 5a) puis former sur cette couche isolante un masque de résine 42i + 1 et procéder de manière classique à la gravure de la couche isolante (figure 5b).

A ce stade comme le montre la figure 5c, on procède à l'enlèvement du masque de résine et au retrait du germanium.

On procède alors comme le montre la figure 5d au dépôt d'une couche de protection, par exemple d'oxyde 43i + 1 pour fermer les espaces inter-connexions et réaliser l'isolation par air.

On peut alors procéder à la réalisation du niveau de métallisation i + 2 en répétant les étapes de formation de vias illustrées par les figures 3a à 3i et de formation de l'isolation par air illustrées par les figures 5a à 5d. Dans ce cas, on procède à la formation de l'isolation par air niveau de métallisation par niveau de métallisation.

Bien évidemment, dans la mise en oeuvre du procédé illustré par les figures 5a à 5d, on peut obtenir une isolation mixte par air et par matériau isolant comme décrit précédemment.

## Revendications

1. Procédé de réalisation d'une isolation par air inter et/ou intra-métallique entre une partie au moins des éléments métalliques conducteurs (11) des niveaux de métallisation d'un circuit intégré, **caractérisé en ce qu'**il comprend le dépôt de germanium polycristallin (12) dans une partie au moins des espaces inter-connexions entre lesdits éléments métalliques conducteurs et l'élimination du germanium pour former des espaces inter-connexions remplis d'air (15) entre les éléments métalliques conducteurs.

2. Procédé selon la revendication 1, **caractérisé en ce qu'**il comprend préalablement au dépôt de germanium polycristallin, un dépôt d'une couche isolante pour protéger les éléments métalliques (11) d'un contact direct avec le germanium polycristallin.

3. Procédé selon la revendication 1 ou 2, pour réaliser une isolation par air intra-métallique entre des éléments métalliques conducteurs (11) d'un même niveau de métallisation **caractérisé en ce qu'**il comprend :
(1) le dépôt dans les espaces inter-connexions entre les éléments métalliques (11) de germanium polycristallin (12) ;
(2) le dépôt sur les éléments métalliques (11) et le germanium polycristallin (12) d'une couche d'un matériau d'isolation (13) ;
(3) la formation sur la couche de matériau d'isolation (13) d'un masque de résine photo-résistante (14) ;
(4) la gravure anisotrope de la couche de matériau d'isolation (13) pour former dans cette couche (13) des ouvertures en regard du germanium polycristallin (12) ; et
(5) l'élimination du germanium polycristallin (12) pour réaliser des espaces inter-connexions remplis d'air (15).

4. Procédé selon la revendication 3, **caractérisé en ce qu'**il comprend en outre le retrait du masque de résine (14) avant ou après l'élimination du germanium polycristallin (12) ou simultanément avec cette dernière.

5. Procédé selon la revendication 3 ou 4, **caractérisé en ce qu'**il comprend le dépôt d'une couche d'un matériau isolant d'encapsulation pour clore les espaces interconnexions (15).

6. Procédé selon la revendication 5, **caractérisé en ce que** le dépôt de la couche de matériau isolant d'encapsulation s'effectue de manière à ce que certains des espaces inter-connexions (15) soient remplis avec le matériau isolant d'encapsulation.

7. Procédé selon la revendication 1, pour réaliser une isolation par air inter et intra-métallique entre au moins une partie des éléments métalliques conducteurs des niveaux de métallisation d'un circuit intégré, **caractérisé en ce qu'**il comprend :
(1) le dépôt de germanium polycristallin (32i) entre et sur les éléments métalliques conducteurs (31i) d'un niveau (i) de métallisation ;
(2) la formation, pour ce niveau (i) de métallisation, des vias métalliques (40i) voulus, cette formation des vias ayant pour résultat de laisser une couche de matériau isolant (33i) sur la surface du dépôt de germanium polycristallin (32i) ;
(3) la formation des éléments métalliques conducteurs (31i + 1) d'un niveau adjacent (i + 1) de métallisation sur la surface de la couche de matériau isolant (33i) recouvrant le dépôt de germanium (32i);
(4) la gravure de la couche de matériau isolant (33i) couvrant la surface du dépôt de germanium (32i) pour faire apparaître le dépôt de germanium (32i) en des emplacements choisis entre les éléments métalliques (31i + 1) du niveau adjacent (i + 1) de métallisation ;
(5) la répétition des étapes (1) à (4) jusqu'à obtention du nombre voulu de niveaux de métallisation, de sorte qu'on obtient un empilement du nombre voulu de niveaux de métallisation dans lequel les dépôts de germanium forment une masse de germanium ininterrompue jusqu'à la surface de l'empilement ; et
(6) l'élimination de la masse de germanium ininterrompue pour former des espaces inter-connexions remplis d'air.

8. Procédé selon la revendication 7, **caractérisé en ce qu'**il comprend le dépôt d'une couche d'un matériau isolant d'encapsulation à la surface du niveau de métallisation le plus externe pour clore les espaces inter-connexions.

9. Procédé selon la revendication 1, pour réaliser une isolation par air inter et intra-métallique entre une partie au moins des éléments métalliques conducteurs des niveaux de métallisation d'un circuit intégré, **caractérisé en ce qu'**il comprend :
(1) le dépôt de germanium polycristallin (32i) entre et sur les éléments métalliques conducteurs (31i) d'un niveau (i) de métallisation ; .
(2) la formation, pour ce niveau (i) de métallisation, des vias métalliques (40i) voulus, cette formation des vias ayant pour résultat de laisser une couche de matériau isolant (33i) sur la surface du dépôt de germanium polycristallin (32i) ;
(3) la formation des éléments métalliques conducteurs (31i + 1) d'un niveau adjacent (i + 1) de métallisation sur la surface de la couche de matériau isolant (33i) recouvrant le dépôt de germanium (32i) ;
(4) la gravure de la couche de matériau isolant (33i) couvrant la surface du dépôt de germanium (32i) pour faire apparaître le dépôt de germanium (32i) en des emplacements choisis entre les éléments métalliques (31i + 1) du niveau adjacent (i + 1) de métallisation ;
(5) l'élimination du germanium pour former des espaces inter-connexions remplis d'air dans le niveau de métallisation (i) ;
(6) le dépôt d'une couche de matériau isolant intermétallique (42i + 1) pour clore les espaces inter-connexions remplis d'air du niveau de métallisation (i) ;
(7) la répétition des étapes (1) à (6) jusqu'à obtention d'un empilement du nombre voulu de niveaux de métallisation comportant des espaces inter-connexions remplis d'air.

10. Procédé selon l'une quelconque des revendications 1 à 9, **caractérisé en ce que** l'élimination du germanium polycristallin comprend la mise en contact du germanium avec une solution oxydante à une température allant de la température ambiante à 200°C.

11. Procédé selon la revendication 10, **caractérisé en ce que** la solution oxydante est l'eau, une solution aqueuse de peroxyde d'hydrogène ou une solution aqueuse diluée de H₂SO₄.

12. Procédé selon l'une quelconque des revendications 1 à 9, **caractérisé en ce que** l'élimination du germanium polycristallin s'effectue au moyen d'un plasma d'oxygène ou d'ozone.

## Claims

1. Process for achieving intermetallic and/or intrametallic isolation between at least some of the conducting metal elements (11) of the metallization levels of an integrated circuit, **characterized in that** it comprises the deposition of polycrystalline germanium (12) in at least some of the interconnect spaces between the said conducting metal elements and the removal of the germanium in order to form air-filled interconnect spaces (15) between the conducting metal elements.

2. Process according to Claim 1, **characterized in that** it comprises, prior to the deposition of polycrystalline germanium, the deposition of an insulating layer in order to protect the metal elements (11) from direct contact with the polycrystalline germanium.

3. Process according to Claim 1 or 2, for achieving intrametallic air isolation between conducting metal elements (11) of the same metallization level, **characterized in that** it comprises:
(1) the deposition of polycrystalline germanium (12) in the interconnect spaces between the metal elements (11);
(2) the deposition of a layer of an insulation material (13) on the metal elements (11) and on the polycrystalline germanium (12);
(3) the formation of a photoresist resin mask (14) on the layer of insulation material (13);
(4) the anisotropic etching of the layer of insulation material (13) in order to form apertures in this layer (13) which are opposite the polycrystalline germanium (12); and
(5) the removal of the polycrystalline germanium (12) in order to produce air-filled interconnect spaces (15).

4. Process according to Claim 3, **characterized in that** it furthermore comprises the removal of the resin mask (14) before or after the polycrystalline germanium (12) has been removed, or simultaneously with this removal.

5. Process according to Claim 3 or 4, **characterized in that** it comprises the deposition of a layer of an insulating encapsulation material in order to close off the interconnect spaces (15).

6. Process according to Claim 5, **characterised in that** the layer of insulating encapsulation material is deposited in such a way that some of the interconnect spaces (15) are filled with the insulating encapsulation material.

7. Process according to Claim 1, for achieving intermetallic and intrametallic air isolation between at least some of the conducting metal elements of the metallization levels of an integrated circuit, **characterized in that** it comprises:
(1) the deposition of polycrystalline germanium (32i) between and on the conducting metal elements (31i) of a metallization level (i);
(2) the formation, for this metallization level (i), of the desired metal vias (40i), this formation of the vias having the result of leaving a layer of insulating material (33i) on the surface of the deposited layer of polycrystalline germanium (32i);
(3) the formation of the conducting metal elements (31i + 1) of an adjacent metallization level (i + 1) on the surface of the layer of insulating material (33i) covering the deposited layer of germanium (32i);
(4) the etching of the layer of insulating material (33i) covering the surface of the deposited layer of germanium (32i) in order to expose the deposited layer of germanium (32i) at selected places between the metal elements (31i + 1) of the adjacent metallization level (i + 1);
(5) the repetition of steps (1) to (4) until the desired number of metallization levels is obtained, so as to obtain a stack of the desired number of metallization levels, in which stack the deposited layers of germanium form a mass of germanium that is uninterrupted as far as the surface of the stack; and
(6) the removal of the uninterrupted mass of germanium in order to form air-filled interconnect spaces.

8. Process according to Claim 7, **characterized in that** it comprises the deposition of a layer of an insulating encapsulation material on the surface of the outermost metallization level in order to close off the interconnect spaces.

9. Process according to Claim 1, for achieving intermetallic and intrametallic air isolation between at least some of the conducting metal elements of the metallization levels of an integrated circuit, **characterized in that** it comprises:
(1) the deposition of polycrytalline germanium (32i) between and on the conducting metal elements (31i) of a metallization level (i);
(2) the formation, for this metallization level (i), of the desired metal vias (40i), this formation of the vias having the result of leaving a layer of insulating material (33i) on the surface of the deposited layer of polycrystalline germanium (32i);
(3) the formation of the conducting metal elements (31i + 1) of an adjacent metallization level (i + 1) on the surface of the layer of insulating material (33i) covering the deposited layer of germanium (32i);
(4) the etching of the layer of insulating material (33i) covering the surface of the deposited layer of germanium (32i) in order to expose the deposited layer of germanium (32i) at selected places between the metal elements (31i + 1) of the adjacent metallization level (i + 1);
(5) the removal of the germanium in order to form air-filled interconnect spaces in the metallization level (i) ;
(6) the deposition of a layer of insulating intermetallic material (42i + 1) in order to close off the air-filled interconnect spaces of the metallization level (i);
(7) the repetition of steps (1) to (6) until a stack of the desired number of metallization levels having air-filled interconnect spaces is obtained.

10. Process according to any one of Claims 1 to 9, **characterized in that** the removal of the polycrystalline germanium entails bringing the germanium into contact with an oxidizing solution at a temperature ranging from room temperature to 200°C.

11. Process according to Claim 10, **characterized in that** the oxidizing solution is water, an aqueous hydrogen peroxide solution or a dilute aqueous H₂SO₄ solution.

12. Process according to any one of Claims 1 to 9, **characterized in that** the polycrystalline germanium is removed by means of an oxygen or ozone plasma.

## Patentansprüche

1. Verfahren zur Herstellung einer Inter- und/oder Intrametallisolation aus Luft zwischen mindestens einem Teil der metallischen Leiterelemente (11) von Metallisierungsebenen einer integrierten Schaltung,
**dadurch gekennzeichnet, daß** es die Abscheidung von polykristallinem Germanium (12) mindestens in einem Teil der Zwischenräume zwischen den metallischen Leiterelementen und die Beseitigung des Germaniums aufweist, um mit Luft gefüllte Zwischenräume (15) zwischen den metallischen Leiterelementen zu erzeugen.

2. Verfahren nach Anspruch 1, **dadurch gekennzeichnet, daß** es vor der Abscheidung von polykristallinem Germanium eine Abscheidung einer isolierenden Schicht aufweist, um die metallischen Elemente (11) vor einem direkten Kontakt mit dem polykristallinen Germanium zu schützen.

3. Verfahren nach Anspruch 1 oder 2 zur Herstellung einer Intrametallisolation aus Luft zwischen den metallischen Leiterelementen (11) derselben Metallisierungsebene, **dadurch gekennzeichnet, daß** es aufweist:
(1) Abscheidung von polykristallinem Germanium (12) in den Zwischenräumen zwischen den metallischen Elementen (11);
(2) Abscheidung einer Schicht (13) eines Isolationsmaterials auf den metallischen Elementen (11) und dem polykristallinen Germanium (12);
(3) Bildung einer Maske (14) aus Photoresist-Harz (14) auf der Isolationsmaterialschicht (13);
(4) anisotrope Ätzung der Isolationsmaterialschicht (13), um in dieser Schicht (13) Öffnungen zum polykristallinen Germanium (12) zu bilden; und
(5) Beseitigung des polykristallinen Germaniums (12), um mit Luft gefüllte Zwischenräume (15) zu erzeugen.

4. Verfahren nach Anspruch 3, **dadurch gekennzeichnet, daß** es ferner das Abnehmen der Harzmaske (14) vor oder nach oder gleichzeitig mit der Beseitigung des polykristallinen Germaniums (12) aufweist.

5. Verfahren nach Anspruch 3 oder 4, **dadurch gekennzeichnet, daß** es die Abscheidung einer Schicht eines isolierenden Einkapselungsmaterials aufweist, um die Zwischenräume (15) zu schließen.

6. Verfahren nach Anspruch 5, **dadurch gekennzeichnet, daß** die Abscheidung der Schicht des isolierenden Einkapselungsmaterials auf eine Weise erfolgt, daß gewisse Zwischenräume (15) mit dem isolierenden Einkapselungsmaterial gefüllt werden.

7. Verfahren nach Anspruch 1 zur Herstellung einer Inter- und Intrametallisolation aus Luft zwischen mindestens einem Teil der metallischen Leiterelemente von Metallisierungsebenen einer integrierten Schaltung, **dadurch gekennzeichnet, daß** es aufweist:
(1) Abscheidung von polykristallinem Germanium (32i) zwischen und auf den metallischen Leiterelementen (31i) einer Metallisierungsebene (i);
(2) Bildung von gewünschten metallischen Durchgängen (40i) für diese Metallisierungsebene (i), wobei diese Bildung von Durchgängen zur Folge hat, daß eine isolierende Materialschicht (33i) auf der Oberfläche der polykristallinen Germanium-Abscheidung (32i) bleibt;
(3) Bildung von metallischen Leiterelementen (31i+1) einer benachbarten Metallisierungsebene (i+1) auf der Oberfläche der die Germanium-Abscheidung (32i) bedeckenden, isolierenden Materialschicht (33i);
(4) Ätzen der die Oberfläche der Germanium-Abscheidung (32i) bedeckenden, isolierenden Materialschicht (33i), um an gewählten Orten zwischen den metallischen Elementen (31i+1) der benachbarten Metallisierungsebene (i+1) die Germanium-Abscheidung (32i) freizulegen;
(5) Wiederholen der Schritte (1) bis (4) bis die gewünschte Anzahl von Metallisierungsebenen erreicht ist, so daß man einen Stapel der gewünschten Anzahl von Metallisierungsebenen erhält, in welchem die Germanium-Abscheidungen eine kontinuierliche Germaniummasse bis zur Oberfläche des Stapels bilden; und
(6) Beseitigung der kontinuierlichen Germaniummasse, um mit Luft gefüllte Zwischenräume zu erzeugen.

8. Verfahren nach Anspruch 7, **dadurch gekennzeichnet, daß** es die Abscheidung einer Schicht eines isolierenden Einkapselungsmaterials an der Oberfläche der äußersten Metallisierungsebene aufweist, um die Zwischenräume zu schließen.

9. Verfahren nach Anspruch 1 zur Herstellung einer Inter- und Intrametallisolation aus Luft zwischen mindestens einem Teil der metallischen Leiterelemente von Metallisierungsebenen einer integrierten Schaltung, **dadurch gekennzeichnet, daß** es aufweist:
(1) Abscheidung von polykristallinem Germanium (32i) zwischen und auf den metallischen Leiterelementen (31i) einer Metallisierungsebene (i);
(2) Bildung von gewünschten metallischen Durchgängen (40i) für diese Metallisierungsebene (i), wobei diese Bildung von Durchgängen zur Folge hat, daß eine isolierende Materialschicht (33i) auf der Oberfläche der polykristallinen Germanium-Abscheidung (32i) bleibt;
(3) Bildung von metallischen Leiterelementen (31i+1) einer benachbarten Metallisierungsebene (i+1) auf der Oberfläche der die Germanium-Abscheidung (32i) bedeckenden, isolierenden Materialschicht (33i);
(4) Ätzen der die Oberfläche der Germanium-Abscheidung (32i) bedeckenden, isolierenden Materialschicht (33i), um an gewählten Orten zwischen den metallischen Elementen (31i+1) der benachbarten Metallisierungsebene (i+1) die Germanium-Abscheidung (32i) freizulegen;
(5) Beseitigung des Germaniums, um mit Luft gefüllte Zwischenräume in der Metallisierungsebene (i) zu erzeugen;
(6) Abscheidung einer Schicht (42i+1) eines Intermetallisolationsmaterials, um die mit Luft gefüllten Zwischenräume der Metallisierungsebene (i) zu schließen;
(7) Wiederholung der Schritte (1) bis (6) bis ein Stapel der gewünschten Anzahl von Metallisierungsebenen erzielt ist, der mit Luft gefüllte Zwischenräume aufweist.

10. Verfahren nach einem der Ansprüche 1 bis 9, **dadurch gekennzeichnet, daß** die Beseitigung des polykristallinen Germaniums das Inkontaktbringen des Germaniums mit einer oxidierenden Lösung bei einer Temperatur, die zwischen der Umgebungstemperatur und 200°C liegt, aufweist.

11. Verfahren nach Anspruch 10, **dadurch gekennzeichnet, daß** die oxidierende Lösung Wasser, eine wäßrige Lösung von Wasserstoffperoxid oder eine verdünnte wäßrige Lösung von H₂SO₄ ist.

12. Verfahren nach einem der Ansprüche 1 bis 9, **dadurch gekennzeichnet, daß** die Beseitigung des polykristallinen Germaniums mit Hilfe eines Sauerstoff- oder Ozonplasmas erfolgt.
